# EUROPEAN PATENT SPECIFICATION

(11) **EP 3 179 837 B1**
(45) Date of publication and mention of the grant of the patent: **03.06.2020**
(21) Application number: 16199808.3
(22) Date of filing: 21.11.2016
(51) Int. Cl.: H05K 7/20

(54) **CONVERTER CELL CAPACITOR COOLING**
WANDLERZELLENKONDENSATORKÜHLUNG
REFROIDISSEMENT DE CONDENSATEUR À CELLULE DE CONVERTISSEUR

(30) Priority: 09.12.2015 EP 15198740
(43) Date of publication of application: 14.06.2017
(73) Proprietor: ABB Schweiz AG, 5400 Baden (CH)
(72) Inventor: Sologubenko, Oleksandr, 8906 Bonstetten (CH); Hemrle, Jaroslav, 5405 Baden-Dättwil (CH); Kaufmann, Lilian, 5413 Birmenstorf (CH)
(74) Representative: Zimmermann & Partner Patentanwälte mbB

(56) References cited:
- JP-A- 2008 277 562
- JP-A- 2008 277 562
- US-A1- 2011 049 976
- US-A1- 2013 107 601

## Description

### FIELD OF THE INVENTION

The invention relates to the field of power electronic converters, specifically to cooling of cell capacitors in Modular Multilevel Converters.

### BACKGROUND OF THE INVENTION

A Modular Multilevel power Converter (MMC), also known as Chain-Link Converter (CLC), comprises a plurality of converter cells, or converter sub-modules, serially connected in converter branches, or phase legs, that in turn may be arranged in a wye/star, delta, and/or indirect converter topology. Each converter cell comprises, in the form of a half-bridge or full-bridge circuit, a capacitor for storing energy and power semiconductor switches such as insulated gate bipolar transistor (IGBT) devices, gate-turn-off thyristor (GTO) devices, integrated gate commutated thyristor (IGCT) devices, or MOSFETs for connecting the capacitor to the converter branch with one or two polarities. The voltage per converter cell capacitor may be between 1 kV and 6 kV; whereas the voltage of a converter branch may be in a range from 10 kV to several 100 kV. An MMC controller with a processor and corresponding software, or a field programmable gate array (FPGA), is responsible for controlling the converter cells and operating the power semiconductor switches by means of a pulse width modulation scheme.

MMCs may be used for a number of applications in electric power transmission and distribution, including High Voltage Direct Current (HVDC) applications as well as Static VAR Compensators (Statcoms) and/or Flexible AC Transmission System (FACTS) applications. The latter include devices for static power-factor correction as well as for voltage quality and stability purposes based on production or absorption of reactive power.

In MMC converter cells, power electronic modules comprising the power semiconductor switches represent the major source of power losses, while some heat is also generated in the cell capacitors. Adequate cooling of both the power electronic modules and cell capacitors is required for proper operation and long lifetime of the convertor components.

Conventionally, power semiconductor switch elements are cooled by forced water flow, while the cell capacitors are cooled by free convection of air, with capacitor containers being exposed via all surfaces to the surrounding circulating air. With the capacitor heating intensity per volume being limited, and despite a rather low thermal conductivity of the container filler material, air cooling on all capacitor container surfaces ensures minimal length of the thermal paths and proves sufficient for preventing undesirable hot spot temperature levels in the capacitor that would significantly affect the life-cycle of the capacitor. However, with increasing footprint requirements, the heat-generating components are packed more closely, the total heating power density increases, and alternative cooling concepts may have to be envisaged.

The patent EP 2277365 B1 discloses a high power drive stack system for cooling of power silicon devices arranged on a plurality of modules which in turn are stacked in a common support structure. A dielectric fluid cooling system utilizes a vaporizable dielectric refrigerant and comprises a plurality of fluid conduits, a condenser, a pump, and an evaporator positioned on at least one module.

### DESCRIPTION OF THE INVENTION

It is an objective of the invention to provide for sufficient cooling of converter cells arranged in a compact design. This objective is achieved by a cooling system and a converter according to the independent claim. Preferred embodiments are evident from the dependent patent claims.

In a stack or succession of converter cells arranged on top of or next to each other, both the power electronics modules and cell capacitors face corresponding components of adjacent converter cells, which requires adequate electric, dielectric, and short-circuit design measures in-between the cells. With increasing footprint requirements, heat-generating components are packed more closely and the space available next to the cell capacitors, specifically between the power electronic modules and the capacitors, becomes scarce. Accordingly, in a compact converter design, circulation of ambient air in a stacking direction may be impeded or reduced to an extent that precludes cooling of the cell capacitors via capacitor surfaces perpendicular to the stacking direction. Here, a cooling system that transfers, via dedicated thermal connections, excess cooling power from forced convection boiling cooling of the power electronic modules to the cell capacitors ensures sufficient cooling of the latter.

According to the invention, a forced convection boiling two-phase cooling system for a converter cell of a multilevel power converter with a cell capacitor for storing energy and with a first and second semiconductor switch element to connect the cell capacitor to cell terminals is proposed. The cooling system includes a first and second evaporator arranged in thermal contact with the semiconductor switch elements and adapted for evaporating a dielectric working or cooling fluid, or refrigerant, with the evaporators being fluidly connected in parallel in a closed working fluid circuit including a pump for circulating the fluid and a central condenser. The cooling system is adapted to thermally connect, or transfer heat from, the cell capacitor to a fluid supply or return line of the working fluid.

In a preferred variant of the invention the cooling system includes a dedicated thermal link or path or other connection with high thermal conductivity, such as a cold finger or a heat pipe, to thermally connect the cell capacitor to a working fluid supply or return line supplying condensed working fluid to and returning evaporated working fluid from the evaporator.

In an advantageous embodiment of the invention a capacitor terminal of the cell capacitor is electrically connected through a capacitor bushing and a capacitor connection to the first semiconductor switch, and the thermal link connects the capacitor connection to the fluid supply or return line. In this case, the thermal link may be electrically conducting without requiring its own bushing. In an alternative advantageous embodiment of the invention an electrically insulating thermal link is provided for thermally connecting the fluid supply or return lines to a surface or housing of the cell capacitor.

The invention is also directed to a Modular Multilevel power Converter (MMC) converter arrangement for HVDC and FACTS applications, with a converter valve including a plurality of series connected converter cells each including a cell capacitor for energy storing purpose and two semiconductor switch elements to connect the cell capacitor to cell terminals, and with a cooling system. The cooling system includes a closed working fluid circuit including a condenser for condensing evaporated working fluid and a pump for circulating the fluid. The cooling system further includes, for each converter cell, a first and second evaporator arranged in thermal contact with the semiconductor switches of the cell, the first and second evaporators being fluidly connected in parallel and adapted to receive condensed dielectric working fluid and to return evaporated working fluid. The cooling system also includes, for each converter cell, a dedicated thermal link with high thermal conductivity adapted to thermally connect, and transfer heat from, the cell capacitor to a fluid supply or return line supplying condensed working fluid and returning evaporated working fluid from the evaporators. In an arrangement as defined here, a converter branch or phase leg may include one or several converter valves, with one independent cooling circuit per converter valve.

In a preferred embodiment of the converter arrangement the fluid supply lines, in the tubing sections connecting to individual evaporators, have flow-restricting throttle elements to balance a flow of working fluid among the different evaporators. In particular, these throttle elements account for gravity in case the converter cells are stacked non-horizontally, specifically vertically.

### BRIEF DESCRIPTION OF THE DRAWINGS

The subject matter of the invention will be explained in more detail in the following text with reference to preferred exemplary embodiments which are illustrated in the attached drawings, in which:
Fig.1 shows a cooling system layout according to the invention;
Fig.2 depicts two embodiments of a thermal link between capacitor and cooling circuit.

### DETAILED DESCRIPTION OF PREFERRED EMBODIMENTS

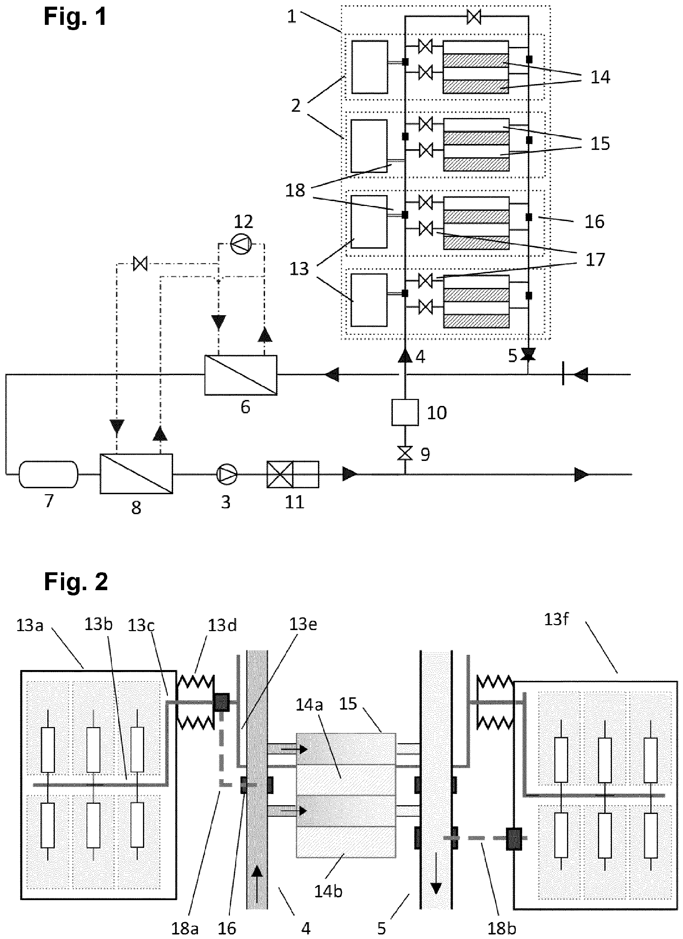

Fig.1 shows the layout of a cooling system for a converter valve 1 with four identical converter cells 2 each with a number of constituents as described further below (wherein, for the sake of legibility, corresponding reference numerals 13 to 18 have not been repeated for all instances). The solid lines indicate the refrigerant or working fluid circuit. Refrigerant in the liquid state is pumped by pump 3 and directed by the tubing or conduits of supply line 4 to evaporators 15 in the cells. Cooling takes place via predominantly latent heat of liquid-vapour phase transition (boiling). The resulting vapour with highest possible quality leaves the converter valve via the tubing of return line 5, and condenses in condenser 6 by means of heat exchange with some cooling media. The liquid refrigerant is then collected in separator 7, further subcooled in sub-cooler heat exchanger 8 which is fluidly connected to pump 3 closing the flow circuit. Several converter valves can be connected to the same supply line in parallel; the refrigerant flow distribution is regulated by valves 9 and controlled by mass flow meter 10. The system also includes one or more filters/driers 11 to remove water from the refrigerant. In exemplary off-shore applications a preferred cooling fluid for heat exchangers 6 and 8 is sea water pumped by pump 12 through tubing denoted by dash-dot lines.

Each converter cell 2 comprises a capacitor 13 and two semiconductor switch elements 14, specifically two IGBT modules. Two evaporators 15 are fluidly connected in parallel to the liquid refrigerant supply line 4 and the vapour return line 5. The lower evaporator is in good thermal and electrical contact with the collector of the lower IGBT module and with the emitter of the upper IGBT module. The upper evaporator is in good thermal and electrical contact with the collector of the upper IGBT module. In case the tubing is made of electrically conducting materials, electrically insulating sections 16 should be added to both supply line 4 and return line 5 in-between the two evaporators 15. In the tubing connecting evaporators 15 with supply line 4, flow-restricting throttle elements 17 are added in order to ensure the homogeneous distribution of fluid through all evaporators of the system. Throttle elements 17 may be valves or small cross-section tubing sections. Ultimately, in order to improve cooling of capacitors 13 according to the invention, thermal links 18 with high thermal conductance are thermally connecting the capacitors with tubing 4 and 5.

Fig.2 shows, on the left-hand side, a first exemplary embodiment of the thermal link between the capacitor and the two-phase cooling circuit. The capacitor housing 13a encloses a number of capacitor elements connected by a capacitor busbar 13b to a first capacitor terminal 13c. The capacitor terminal in turn is connected, by means of capacitor bushing 13d and first electrical capacitor connection 13e, to a first semiconductor switch element 14a. A branch of the first electrical capacitor connection leads to a neighbouring converter cell (not depicted), while a second capacitor terminal (not depicted) is connected to the second semiconductor switch element 14b. A first thermal link 18a is provided between the capacitor bushing 13d and an electrically insulating section 16 of the supply line 4.

Fig.2 shows, on the right-hand side, a second exemplary embodiment of the thermal link between the capacitor and the two-phase cooling circuit. Specifically, a second thermal link 18b is provided between a capacitor housing 13f and the return line 5. The thermal link according to the second embodiment may be alternative or complementary to a thermal link according to the first embodiment, and both thermal links 18a, 18b may use either of the supply line 4 and the return line 5 as a heat sink and preferably end at electrically insulating sections in-between the two evaporators of a cell.

The thermal network between the heat sources within the capacitor housings and the two-phase cooling circuit includes various thermal resistances, in particular relating to conductive heat transfer inside the capacitor container. The thermal resistance for collection and transfer of heat from the capacitor elements towards the capacitor bushing is determined by the design, including geometry and material properties, of the capacitor internal busbar. The design of the busbar may focus exclusively on the electrical properties, and disregard thermal properties, if a capacitor-internal heat collector as a heat transfer facilitator, electrically isolated from yet adjacent to the busbar, is provided.

In any compact converter design the available space for convective air, sensors and control elements is inherently limited. In case of a converter valve immersed in dielectric gas a minimum distance between the cell capacitor and other converter elements is inversely proportional to a dielectric breakdown electric field strength of the dielectric gas. Accordingly, even between an outer surface of the cell capacitor and a dielectric gas enclosure there may not be sufficient space for circulating a cooling medium, in addition to the actual absence of such cooling medium, and alternative cell capacitor cooling concepts as described in this application are all the more beneficial.

The total flow rate of the refrigerant for the system is selected such that the total latent heat of boiling is equal or higher than the total heat losses in the semiconductor switch elements and cell capacitors. The total flow rate should be minimized in order to reduce the pumping power, yet it should be large enough to avoid dry-out in any of evaporators. The equivalent flow distribution between different evaporators connected fluidly in parallel is assured by throttle elements, having each different flow resistances specific for each evaporator and compensating, e.g., for the difference in the elevation-dependent pressure of the fluid. The flow resistance of throttle elements can be either fixed or variably determined in dependence on a temperature measurement at the IGBT modules. The two-phase cooling leads to a very homogeneous distribution of temperature across the IGBT modules of the converter valve.

The non-flammable dielectric refrigerant may be a refrigerant known as R134a, or alternatives with a lower global warming potential, such as R1234yz or similar. Flow rates may depend on the type of the two-phase refrigerant and may be of the order of 0.01 kg/s per cell, and thus one order of magnitude lower than for conventional water cooling. The lower flow rates of the cooling fluid result in reduced wear of the tubing and, for the case of horizontal converter valve arrangement, a considerable reduction of pump load, as well as in a considerably lower total mass of cooling fluid. In addition, dielectric properties of a number of refrigerant fluids are more favourable for high-voltage applications than those of water which requires deionizing equipment to be included in the cooling system.

The condenser and sub-cooler may reject the heat to ambient air, to thermal loads, or to a water bath e.g. on off-shore platforms. For highest cooling performance, the cooler can be also cooled by active refrigeration circuit to suppress the working fluid temperature even below ambient, subject to techno-economic optimization. The connection can be direct (refrigerant to the ambient cooling medium) or indirect (via intermediate loop, e.g. clean water).

While the invention has been described in detail in the drawings and foregoing description, such description is to be considered illustrative or exemplary and not restrictive. Variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. The mere fact that certain elements or steps are recited in distinct claims does not indicate that a combination of these elements or steps cannot be used to advantage.

## Claims

1. A two-phase cooling system for a converter cell (2) with a cell capacitor (13) and with a first and second semiconductor switch element (14), including
- a closed working fluid circuit including a condenser (8) for condensing evaporated working fluid and a pump (3) for circulating the working fluid;
a first and second evaporator (15) arranged in thermal contact with the semiconductor switch elements and adapted for receiving condensed dielectric working fluid, evaporating the dielectric working fluid, and returning the evaporated working fluid, **characterized by** a thermal link (18) adapted to thermally connect the cell capacitor (13) to a supply (4) or return (5) line of the closed working fluid circuit.

2. The cooling system of claim 1, **characterized in that** a thermal link (18) is provided for thermal connection of the cell capacitor to a working fluid supply (4) or return (5) line.

3. The cooling system of claim 2, wherein a capacitor terminal (13c) of the cell capacitor is electrically connected through a capacitor bushing (13d) and a capacitor connection (13e) to the first semiconductor switch element, **characterized in that** the thermal link (18a) connects the capacitor connection to the fluid supply or return line.

4. The cooling system of claim 2, **characterized in that** the thermal link (18b) connects the fluid supply or return line to a surface (13f) of the cell capacitor.

5. The cooling system of claim 2, **characterized in that** a heat-collector internal to the cell capacitor is provided for to transfer heat from within the cell capacitor to a capacitor surface.

6. The cooling system of claim 2, **characterized in that** electrically insulating sections (16) are provided in the fluid supply and return lines.

7. A converter with a plurality of series connected converter cells (2) each including a cell capacitor (13) and two semiconductor switch elements (14), wherein the converter comprises a cooling system according to any one of claims 1 to 6, wherein the first and second evaporator (15) are arranged in thermal contact for each converter cell.

8. The converter according to claim 7, **characterized in that** the fluid supply lines have flow-restricting throttle elements (17) to balance a flow of working fluid among the evaporators.

## Patentansprüche

1. Zweiphasen-Kühlsystem für eine Wandlerzelle (2) mit einem Zellenkondensator (13) und mit einem ersten und zweiten Halbleiterschalterelement (14), einschließend
- einen geschlossenen Arbeitsfluidkreis mit einem Verflüssiger (8) zum Kondensieren von verdampftem Arbeitsfluid und einer Pumpe (3) zum Umwälzen des Arbeitsfluids;
einen ersten und zweiten Verdampfer (15), die in Wärmekontakt mit den Halbleiterschalterelementen angeordnet und ausgelegt sind zum Empfangen von kondensiertem dielektrischem Arbeitsfluid, Verdampfen des dielektrischen Arbeitsfluids und Rückführen des verdampften Arbeitsfluids,
**gekennzeichnet durch** eine Wärmebrücke (18), die ausgelegt ist zum thermischen Verbinden des Zellenkondensators (13) mit einer Versorgungsleitung (4) oder Rückleitung (5) des Arbeitsfluidkreises.

2. Kühlsystem nach Anspruch 1, **dadurch gekennzeichnet, dass** eine Wärmebrücke (18) für eine thermische Verbindung des Zellenkondensators mit einer Arbeitsfluidversorgungsleitung (4) oder -rückleitung (5) vorgesehen ist.

3. Kühlsystem nach Anspruch 2, wobei ein Kondensatoranschluss (13c) des Zellenkondensators durch eine Kondensatordurchführung (13d) und eine Kondensatorverbindung (13e) elektrisch mit dem ersten Halbleiterschalterelement verbunden ist, **dadurch gekennzeichnet, dass** die Wärmebrücke (18a) die Kondensatorverbindung mit der Fluidversorgungs- oder - rückleitung verbindet.

4. Kühlsystem nach Anspruch 2, **dadurch gekennzeichnet, dass** die Wärmebrücke (18b) die Fluidversorgungs- oder -rückleitung mit einer Oberfläche (13f) des Zellenkondensators verbindet.

5. Kühlsystem nach Anspruch 2, **dadurch gekennzeichnet, dass** ein Wärmesammler innerhalb des Zellenkondensators zum Transferieren von Wärme von innerhalb des Zellenkondensators zu einer Kondensatoroberfläche vorgesehen ist.

6. Kühlsystem nach Anspruch 2, **dadurch gekennzeichnet, dass** elektrisch isolierende Abschnitte (16) in der Fluidzufuhr- und -rückleitung vorgesehen sind.

7. Wandler mit mehreren in Reihe geschalteten Wandlerzellen (2) jeweils einschließlich eines Zellenkondensators (13) und zwei Halbleiterschalterelementen (14), wobei der Wandler ein Kühlsystem nach einem der Ansprüche 1 bis 6 umfasst, wobei der erste und zweite Verdampfer (15) in Wärmekontakt für jede Wandlerzelle angeordnet sind.

8. Wandler nach Anspruch 7, **dadurch gekennzeichnet, dass** die Fluidversorgungsleitungen flussbeschränkende Drosselelemente (17) aufweisen, um einen Fluss von Arbeitsfluid unter den Verdampfern auszugleichen.

## Revendications

1. Système de refroidissement à deux phases pour une cellule (2) de convertisseur dotée d'un condensateur (13) de cellule et de premier et second éléments de commutation à semi-conducteurs (14), comportant
- un circuit de fluide actif fermé comprenant un condenseur (8) pour condenser un fluide actif évaporé et une pompe (3) pour faire circuler le fluide actif ;
un premier et un second évaporateur (15) agencés en contact thermique avec les éléments de commutation à semi-conducteurs et conçus pour recevoir un fluide actif diélectrique condensé, évaporer le fluide actif diélectrique, et renvoyer le fluide actif évaporé,
**caractérisé par** une liaison thermique (18) conçue pour relier thermiquement le condensateur (13) de cellule à une ligne d'alimentation (4) ou de retour (5) du circuit de fluide actif fermé.

2. Système de refroidissement selon la revendication 1, **caractérisé en ce qu'**une liaison thermique (18) est prévue pour une connexion thermique du condensateur de cellule à une ligne d'alimentation (4) ou de retour (5) de fluide actif.

3. Système de refroidissement selon la revendication 2, dans lequel une borne (13c) de condensateur du condensateur de cellule est connectée électriquement au moyen d'un raccord (13d) de condensateur et d'une connexion (13e) de condensateur au premier élément de commutation à semi-conducteurs, **caractérisé en ce que** la liaison thermique (18a) relie la connexion de condensateur à la ligne d'alimentation ou de retour de fluide.

4. Système de refroidissement selon la revendication 2, **caractérisé en ce que** la liaison thermique (18b) relie la ligne d'alimentation ou de retour de fluide à une surface (13f) du condensateur de cellule.

5. Système de refroidissement selon la revendication 2, **caractérisé en ce qu'**un collecteur de chaleur interne au condensateur de cellule est fourni pour transférer la chaleur provenant de l'intérieur du condensateur de cellule vers une surface de condensateur.

6. Système de refroidissement selon la revendication 2, **caractérisé en ce que** des sections électriquement isolantes (16) sont prévues dans les lignes d'alimentation et de retour de fluide.

7. Convertisseur doté d'une pluralité de cellules de convertisseur connectées en série (2) comprenant chacune un condensateur (13) de cellule et deux éléments de commutation à semi-conducteurs (14), le convertisseur comprenant un système de refroidissement selon l'une quelconque des revendications 1 à 6, dans lequel les premier et second évaporateurs (15) sont disposés en contact thermique pour chaque cellule de convertisseur.

8. Convertisseur selon la revendication 7, **caractérisé en ce que** les lignes d'alimentation en fluide comprennent des éléments d'étranglement limitant l'écoulement (17) pour équilibrer un écoulement d'un fluide actif parmi les évaporateurs.
